# EUROPEAN PATENT APPLICATION

(11) **EP 2 554 582 A1**
(43) Date of publication of application: **06.02.2013**
(21) Application number: 11762771.1
(22) Date of filing: 28.03.2011
(51) Int. Cl.: C08J 7/00, C23C 14/48, G02F 1/1333

(54) **COMPACT, PRODUCTION METHOD THEREFOR, ELECTRONIC DEVICE MEMBER AND ELECTRONIC DEVICE**

(30) Priority: 29.03.2010 JP 2010075083
(71) Applicant: LINTEC Corporation, Tokyo 173-0001 (JP)
(72) Inventor: IWAYA Wataru, Tokyo 173-0001 (JP); KONDO Takeshi, Tokyo 173-0001 (JP); NAGANAWA Satoshi, Tokyo 173-0001 (JP)
(74) Representative: Albrecht, Thomas
(86) International application number: PCT/JP2011/057609
(87) International publication number: WO 2011/122547

(57) **Abstract**

Provided is a formed article including a layer obtained by implanting ions of a hydrocarbon compound into a polysilazane compound-containing layer. Also provided are a method for producing the formed article, an electronic device member including the formed article, and an electronic device including the electronic device member. The formed article exhibiting an excellent gas barrier capability and excellent bending resistance, a method for producing the formed article, and an electronic device member, or the like, comprising the formed article are provided.

## Description

### TECHNICAL FIELD

The invention relates to a formed article, a method for producing the same, an electronic device member that includes the formed article, and an electronic device that includes the electronic device member.

### BACKGROUND ART

A polymer formed article (e.g., plastic film) that is inexpensive and exhibits excellent workability is provided with a desired function, and used in various fields.
For example, a gas-barrier plastic film that does not allow water vapor and oxygen to pass through is used as a food/drug packaging film in order to suppress oxidation and denaturation of proteins, oils, fats, and the like to keep taste and freshness.

In recent years, use of a transparent plastic film as an electrode substrate instead of a glass plate has been studied for displays (e.g., liquid crystal display and electroluminescence (EL) display) in order to implement a reduction in thickness, a reduction in weight, an improvement in flexibility, and the like. However, since a plastic film tends to allow water vapor, oxygen, and the like to pass through as compared with a glass plate, elements provided in a display may deteriorate.

In order to solve this problem, Patent Document 1 proposes a flexible display substrate in which a transparent gas barrier layer formed of a metal oxide is stacked on a transparent plastic film.
However, since the transparent gas barrier layer formed of a metal oxide is stacked on the surface of the transparent plastic film by deposition, ion plating, sputtering, or the like, cracks may occur in the gas barrier layer when the substrate is rolled up or bent, so that the gas barrier capability may deteriorate.

Patent Document 2 discloses a method that produces a gas barrier film by forming a polysilazane film on at least one side of a film, and subjecting the polysilazane film to a plasma treatment. When using the method disclosed in Patent Document 2, however, a sufficient gas barrier capability cannot be obtained unless the thickness of the gas barrier layer is reduced to a micrometer level. For example, Patent Document 2 states that a water vapor transmission rate of 0.50 g/m²/day is obtained when the gas barrier layer has a thickness of 0.1 µm.

A film that exhibits antistatic performance has also been desired to protect an electrostatic-sensitive element (e.g., electronic parts) or prevent adhesion of dust (see Patent Document 3). A film having a surface resistivity of 1 ×10⁸ to 1×10¹² Ω/sq is considered to exhibit antistatic performance when grounded.

### RELATED-ART DOCUMENT

### PATENT DOCUMENT

Patent Document 1: JP-A-2000-338901
Patent Document 2: JP-A-2007-237588
Patent Document 3: JP-A-62-220330

### SUMMARY OF THE INVENTION

### TECHNICAL PROBLEM

The invention was conceived in view of the above situation. An object of the invention is to provide a formed article that exhibits an excellent gas barrier capability and excellent bending resistance, a method for producing the same, an electronic device member that includes the formed article, and an electronic device that includes the electronic device member.

### SOLUTION TO PROBLEM

The inventors of the invention conducted extensive studies in order to achieve the above object, and found that a desired formed article can be conveniently and efficiently produced by implanting ions of a hydrocarbon compound into a polysilazane compound-containing layer of a formed body that includes the polysilazane compound-containing layer in the surface area. This finding has led to the completion of the invention.

A first aspect of the invention provides the following formed article (see (1) to (5)).
(1) A formed article including a layer obtained by implanting ions of a hydrocarbon compound into a polysilazane compound-containing layer.
(2) The formed article according to therein the layer has been obtained by implanting ions of the hydrocarbon compound into the polysilazane compound-containing layer by a plasma ion implantation method.
(3) The formed article according to our (2), wherein the polysilazane compound is perhydropolysilazane.
(4) The formed article according to (1) or (2), the formed article having a water vapor transmission rate at a temperature of 40°C and a relative humidity of 90% of 0.4 g/m²/day or less.
(5) The formed article according to (1) or (2), the formed article having a surface resistivity of 1×10¹⁴ Ω/sq or less.

A seconds aspect of the invention provides the following method for producing a formed article (see (6) and (7)).
(6) A method for producing the formed article according to (1) or (2), the method including implanting ions of a hydrocarbon compound into a surface area of a polysilazane compound-containing layer of a formed body that includes the polysilazane compound-containing layer in a surface area.
(7) A method for producing the formed article according to (1) or (2), the method, including implanting ions of a hydrocarbon compound into a polysilazane compound-containing layer of a long formed body that includes the polysilazane compound-containing layer in a surface area while feeding the formed body in a given direction.

A third aspect of the invention provides the following electronic device member (see (8)).
(8) An electronic device member including the formed article according to (1) or (2).
   A fourth aspect of the invention provides the following electronic device (see (9)).
(9) An electronic device including the electronic device member according to (8).

### ADVANTAGEOUS EFFECTS OF THE INVENTION

The formed article according to the first aspect of the invention exhibits an excellent gas barrier capability and excellent bending resistance. Therefore, the formed article may suitably be used as an electronic device member for flexible displays, solar cells (e.g., solar cell backsheet), and the like.
The method according to the second aspect of the invention provide a formed article that exhibits an excellent gas barrier capability, excellent bending resistance, and excellent antistatic performance can be safely and conveniently produced by a single process by utilizing the method According to the second aspect of the invention. Moreover, an increase in area of the formed article can be easily achieved at low cost as compared with the case of depositing an inorganic film.
The electronic device member according to the third aspect of the invention exhibits an excellent gas barrier capability, excellent transparency, excellent bending resistance, and the like, and may suitably be used for electronic devices such as displays and solar cells.

### BRIEF DESCRIPTION OF THE DRAWINGS

FIG. 1 is a view showing a schematic configuration of a plasma ion implantation apparatus.
FIG. 2 is a view showing a schematic configuration of a plasma ion implantation apparatus.

### DESCRIPTION OF EMBODIMENTS

A formed article, a method for producing a formed article, an electronic device member, and an electronic device according to embodiment of the invention are described in detail below.

### 1) Formed article

A formed article according to one embodiment of the invention includes a layer (hereinafter may be referred to as "ion-implanted layer") obtained by implanting ions of a hydrocarbon compound into a polysilazane compound-containing layer (hereinafter may be referred to as "polysilazane layer").

The polysilazane compound used in confection with the invention is a polymers compound that includes a repeating unit that includes an -Si-N- bond in the molecule. The polysilazane compound is preferably a compound that includes a repeating unit shown by the following formula. (1).

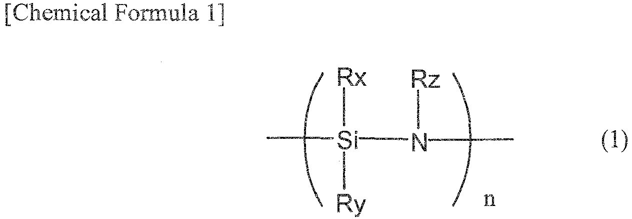

The number average molecular weight of the polysilazane compound is not particularly limited, but is preferably 100 to 50,000.

In the formula (1), n is an arbitrary natural number.
Rx, Ry, and Rz independently represent a hydrogen atom or a non-hydrolyzable group such as a substituted or unsubstituted alkyl group, a substituted or unsubstituted cycloalkyl group, a substituted or unsubstituted alkenyl group, a substituted or unsubstituted aryl group, or an alkylsilyl group.

Examples of the alkyl group include alkyl groups having 1 to 10 carbon atoms (e.g., methyl group, ethyl group, n-propyl group, isopropyl group, n-butyl group, isobutyl group, sec-butyl group, t-butyl group, n-pentyl group, isopentyl group, neopentyl group, n-hexyl group, n-heptyl group, and n-octyl group).

Examples of the unsubstituted cycloalkyl group include cyloalkyl groups having 3 to 10 carbon atoms (e.g., cyclobutyl group, cyclopentyl group, cyclohexyl group, and cycloheptyl group).

Examples of the unsubstituted alkenyl group include alkenyl groups having 2 to 10 carbon atoms (e.g., vinyl group, 1-propenyl group, 2-propenyl group, 1-butenyl group, 2-butenyl group, and 3-butenyl group).

Examples of a substituent that may substitute the alkyl group, the cycloalkyl group, and the alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the unsubstituted aryl group include aryl groups having 6 to 10 carbon atoms (e.g., phenyl group, 1-naphthyl group, and 2-naphthyl group).

Examples or a substituent that may substitute the aryl group includes halogen atoms such as a fluorine atom, a chlorine atom, a bromine atoms, and an iodine atom; alkyl groups having 1 to 6 carbon atoms, such as a methyl group and an ethyl group; alkoxy groups having 1 to 6 carbon atoms, such as a methoxy group and an ethoxy group; a nitro group; a cyano group; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the alkylsilyl group include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, an ethylsilyl group, and the like.

Among these, a hydrogen atom, an alkyl group having 1 to 6 carbon atoms, or a phenyl group is preferable as Rx, Ry, and Rz. A hydrogen atom is particularly preferable as Rx, Ry, and Rz.

The polysilazane compound that includes the repeating unit shown by the formula (1) may be an inorganic polysilazane in which Rx, Ry, and Rz represent a hydrogen atom, or an organic polysilazane in which at least one of Rx, Ry, and Rz does not represent a hydrogen atom.
Examples of the inorganic polysilazane include a perhydropolysilazane that has a linear structure that includes a repeating unit shown by the following formula, has a molecular weight of 690 to 2000, and includes three to ten SiH₃ groups in one molecule (see JP-B-S63-16325),

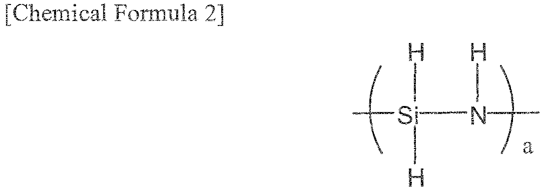

wherein a is an arbitrary natural number, a perhydropolysilazane that has a linear structure and a branched structure, and includes a repeating unit shown by the following formula (A),

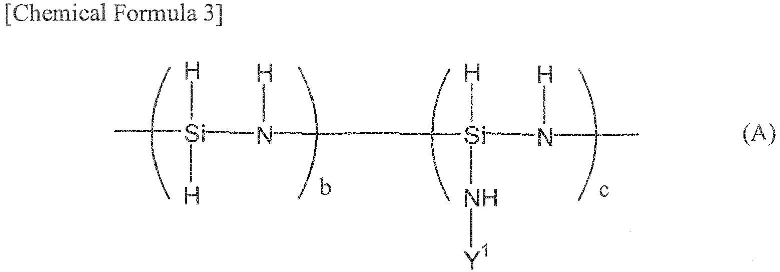

wherein b and c are arbitrary natural numbers, and represents a hydrogen atom or a group shown by the following formula (B),

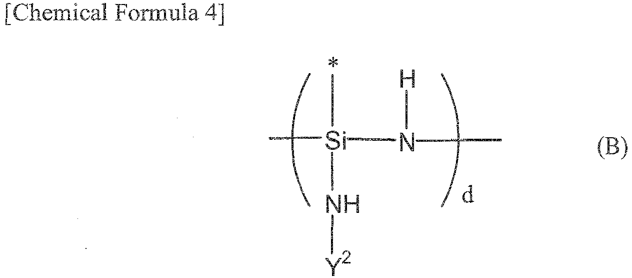

wherein d is an arbitrary natural number, * indicates the bonding position, and Y² represents a hydrogen atom or the group shown by the formula (B), a perhydropolysilazane that has a linear structure, a branched structure, and a cyclic structure in the molecule, and includes the perhydropolysilazane structure shown by the following formula (C),

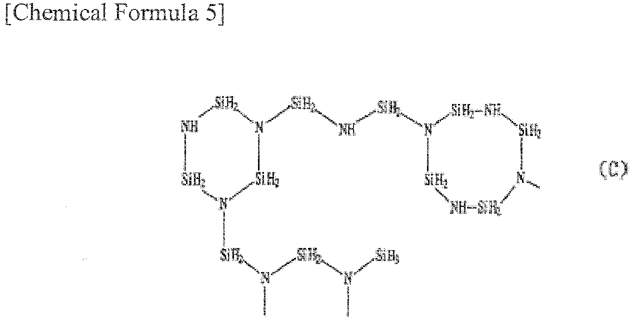

and the like.

Examples of the organic polysilazane include
(i) a polysilazane that includes a repeating unit shown by -(Rx'SiHNH)-(wherein Rx' represents a substituted or unsubstituted alkyl group, a substituted or unsubstituted cycloalkyl group, a substituted or unsubstituted alkenyl group, a substituted or unsubstituted aryl group, or an alkylsilyl group (hereinafter Rx' is the same)), and has a cyclic structure having mainly a degree of polymerization of 3 to 5,
(ii) a polysilazane that includes a repeating unit shown by -(Rx'SiHNRz')- (wherein Rz' represents a substituted or unsubstituted alkyl group, a substituted or unsubstituted cycloalkyl group, a substituted or unsubstituted alkenyl group, a substituted or unsubstituted aryl group, or an alkylsilyl group), and has a cyclic structure having mainly a degree of polymerization of 3 to 5,
(iii) a polysilazane that includes a repeating unit shown by -(Rx'Ry'SiNH)- (wherein Ry' represents a substituted or unsubstituted alkyl group, a substituted or unsubstituted cycloalkyl group, a substituted or unsubstituted alkenyl group, a substituted or unsubstituted aryl group, or an alkylsilyl group), and has a cyclic structure having mainly a degree of polymerization of 3 to 5, (iv) a polyorgano(hydro)silazane that includes a structure shown by the following formula in the molecule,

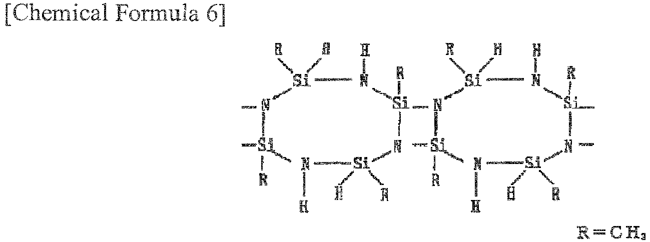

(v) a polysilazane that includes a repeating unit shown by the following formula,

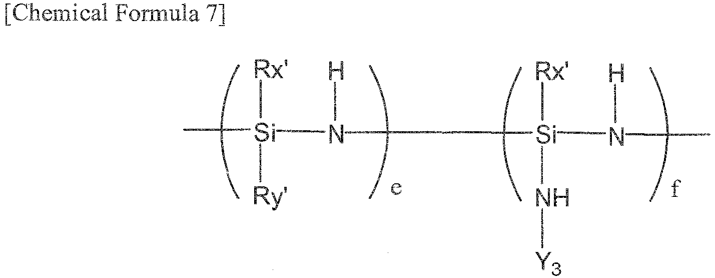

wherein Rx' and Ry' are the same as defined above, e and f are arbitrary natural numbers, and Y³ represents a hydrogen atom or a group shown by the following formula (E),

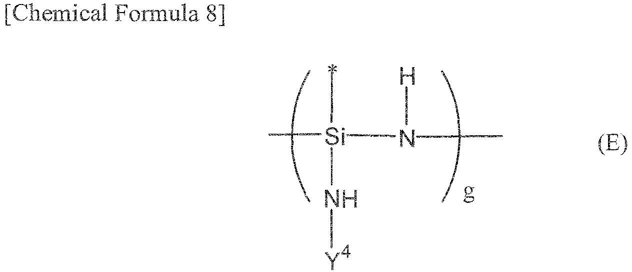

wherein g is an arbitrary natural number, * indicates the bonding position, and Y⁴ represents a hydrogen atom or a group shown by the formula (E), and the like.

The above organic polysilazanes may be produced by a known method. For example, the above organic polysilazane may be produced by reacting ammonia or a primary amine with a reaction product of a substituted or unsubstituted halogenosilane compound shown by the following formula (2) and a secondary amine.

[Chemical Formula 9]

R¹₄₋ₘSiXₘ (2)

wherein m is 2 or 3, X represents a halogen atom, and R¹ represents the substituent Rx, Ry, Rz, Rx', Ry', or Rz'.
The secondary amine, ammonia, and the primary amine may be appropriately selected depending on the structure of the target polysilazane compound.

A modified polysilazane may also be used as the polysilazane compound in the present invention. Examples of the modified polysilazane includes a polymetallosilazane that includes a metal atom (which may be crosslinked), a polysiloxazane that includes a repeating unit shown by (SiH₂)g(NH)ₕ and a repeating unit shown by (SiH₂)ᵢO (wherein g, h, and i are independently 1, 2, or 3) (see JP-A-62-195024), a polyborosilazane produced by reacting a polysilazane with a boron compound (see JP-A-2-84437), a polymetallosilazane produced by reacting a polysilazane with a metal alkoxide (see JP-A-63-81122, for example), an inorganic silazane polymer and a modified polysilazane (see JP-A-1-138108, for example), a copolymer silazane produced by introducing an organic component into a polysilazane (JP-A-2-175726, for example), a low-temperature ceramic polysilazane obtained by adding a ceramic-forming catalyst compound to a polysilazane (see JP-A-5-238827, for example),

a silicon alkoxide-addition polysilazane (see JP-A-5-238827), a glycidol-addition polysilazane (see JP-A-6-122852), an acetylacetonato complex-addition polysilazane (see JP-A-6-306329), a metal carboxylate-addition polysilazane (see JP-A-6-299118, for example),

a polysilazane composition produced by adding an amine and/or an acid to the above polysilazane or modified polysilazane (see JP-A-9-31333), a modified polysilazane produced by adding an alcohol (e.g., methanol) or hexamethyldisilazane to the end nitrogen (N) atom of perhydropolysilazane (see JP-A-5-345826 and JP-A-4-63833), and the like.

Among these, perhydropolysilazane in which Rx, Ry, and Rz represent a hydrogen atom is preferable as the polysilazane compound from the viewpoint of availability and a capability to form an ion-implanted layer that exhibits an excellent gas barrier capability.

A product commercially available as a glass coating material or the like may be used directly as the polysilazane compound.

The polysilazane compound-containing layer may includes an additional component other than the polysilazane compound as long as the object of the invention is not impaired. Examples of the additional component include a curling agent, an additional polymer, an aging preventive, a light stabilizer, a flame retardant, and the like.

The content of the polysilazane compound in the polysilazane compound-containing layer is preferably 50 wt% or more, and more preferably 70 wt% or more, from the viewpoint of forming an ion-implanted layer that exhibits an excellent gas barrier capability and the like.

The polysilazane compound-containing layer may be formed by an arbitrary method. For example, the polysilazane compound-containing layer may be formed by applying a solution that includes at least one polysilazane compound, an optional additional component, and a solvent to an appropriate base layer, and appropriately drying the resulting film.

A spin coater, a knife coater, a gravure coaler, or the like may be used to apply the solution.

It is preferable to heat the film in order to dry the film, and improve the gas barrier capability of the resulting formed article, In this case, the film is heated at 80 to 150°C for several tens of seconds to several tens of minutes.

The polysilazane compound-containing layer may also be formed by causing gas of a plasma-polymerizable silazane compound (e.g., dimethyldisilazane, tetramethyldisilazane, or hexamethyldisilazane) to come in contact with a plastic formed article, and subjecting the resulting product to plasma polymerization (see JP-A-9-143289).

The thickness of the polysilazane compound-containing layer is not particularly limited, but is normally 20 nm to 100 µm, preferably 30 to 500 nm, and more preferably 40 to 200 nm.
According to one embodiment of the invention, a formed article that exhibits a sufficient gas barrier capability can be obtained even if the polysilazane compound-containing layer has a thickness at a nanometer level.

The ion-implanted layer of the formed article according to one embodiment of the invention is not particularly limited as long as the ion-implanted layer is a layer which includes at least one polysilazane compound and into which ions of a hydrocarbon compound are implanted.

The molecular weight of the hydrocarbon compound (raw material gas) that produces ions is formally 1000 or less, preferably 500 or less, and more preferably 200 or less.

Examples of the hydrocarbon compound gas include alkane gas such as methane, ethane, propane, butane, pentane, and hexane; alkene gas such as ethylene, propylene, butene, and pentene; alkadiene gas such as pentadiene and butadiene; alkyne gas such as acetylene and methylacetylene; aromatic hydrocarbon gas such as benzene, toluene, xylene, indene, naphthalene, and phenanthrene; cycloalkane gas such as cyclopropane and cyclohexane; cycloalkene gas such as cyclopentene and cyclohexene; and the like.
These gases may be used either alone or in combination.

It is preferable to use hydrocarbon compound gas having 2 to 10 carbon atoms, more preferably alkene gas (e.g., ethylene, propylene, butene, and butadiene), alkyne gas (e.g., acetylene and propyne), or aromatic hydrocarbon gas (e.g., benzene, toluene, and xylene), still more preferably alkyne gas or aromatic hydrocarbon gas, and particularly preferably ethylene gas, acetylene gas, and toluene gas, since a formed article that exhibits a more excellent gas barrier capability and the like can be more conveniently obtained.

The dose of ions of the hydrocarbon compound may be appropriately determined depending on the application (usage) of the resulting formed article (e.g., gas barrier capability and transparency required for the application), and the like.

Ions of the hydrocarbon compound (hereinafter may be referred to as "ion") may be implanted by an arbitrary method. For example, a method that includes forming a polysilazane compound-containing layer, and implanting ions into the polysilazane compound-containing layer may be used.

Ions may be implanted by applying ions (ion beams) accelerated by an electric field, or implanting ions present in plasma (plasma ion implantation method), for example. It is preferable to use the plasma ion implantation method since a formed article that exhibits an excellent gas barrier capability and the like can be conveniently obtained.

The plasma ion implantation, method may be implemented by generating plasma in an atmosphere containing a plasma-generating gas of a hydrocarbon compound, and implanting ions (cations) in the plasma into the surface area of the polysilazane compound-containing layer by applying a negative high voltage pulse to the polysilazane compound-containing layer, for example.

The thickness of the ion-implanted layer may be controlled by adjusting the implantation conditions, (e.g., type of ions, applied voltage, and implantation time), and may be determined depending on the thickness of the polysilazane compound-containing layer, the application (usage) of the formed article, and the like. The thickness of the ion-implanted layer is normally 10 to 1000 nm.

Whether or not an ion-implanted layer has been formed may be determined by performing elemental analysis on the surface area having a depth up to about 10 nm using X-ray photoelectron spectroscopy (XPS).

The shape of the formed article according to one embodiment of the invention is not particularly limited. For example, the formed article may be in the shape of a film, a sheet, a rectangular parallelepiped, a polygonal prism, a tube, or the like. When using the formed article as an electronic device member (described later), the formed article is preferably in the shape of a film or a sheet. The thickness of the film may be appropriately determined depending on the application of the electronic device.

The formed article according to one embodiment of the invention may include only the ion-implanted layer, or may further include an additional layer. The additional layer may be a single layer, or may include a plurality of identical or different layers.
Examples of the additional layer include a base layer, an inorganic compound layer, an impact-absorbing layer, a conductor layer, a primer layer, and the like.

When the formed article according to one embodiment of the invention is a laminate that includes the ion-implanted layer and the additional layer, these layers may be stacked in an arbitrary order. The ion-implanted layer may be situated at an arbitrary position, but is preferably formed in the surface area of the formed article from the viewpoint of production efficiency and the like. The ion-implanted layer may be formed on one side or each side of the additional layer.

When the formed article according to one embodiment of the invention is a laminate that includes the ion-implanted layer and the additional layer, the thickness of the laminate is not particularly limited, and may be appropriately determined depending on the application of the electronic device.

### Base layer

A material for forming the base layer is not particularly limited as long as the object of the formed article is not impaired. Examples of the material for forming the base layer include polyimides, polyamides, polyamideimides, polyphenylene ethers, polyether ketones, polyether ether ketones, polyolefins, polyesters, polycarbonates, polysulfones, polyether sulfones, polyphenylene sulfides, polyallylates, acrylic resins, cycloolefin polymers, aromatic polymers, and the like.

Among these, polyesters, polyamides, or cycloolefin polymers are preferable due to excellent transparency and versatility. It is more preferable to use polyesters or cycloolefin polymers.

Examples of the polyesters includes polyethylene terephthalate, polybuthylene terephthalate, polyethylene naphthalate, polyallylate, and the like.
Examples of the polyamides include wholly aromatic polyamides, nylon 6, nylon 66, nylon copolymers, and the like.

Examples of the cycloolefin polymers includes norbornene polymers, monocyclic olefin polymers, cyclic conjugated diene polymers, vinyl alicyclic hydrocarbon polymers, and hydrogenated products thereof. Specific examples of the cycloolefin polymers include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.

### Inorganic compound layer

The inorganic compound layer is formed of one or more inorganic compounds. Examples of the inorganic compound that forms the inorganic compound layer include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride). Among these, it is preferable to use an inorganic oxide, an inorganic nitride, or an inorganic oxynitride.

Examples of the inorganic oxide include metal oxides shown by MOx.
Note that M represents a metal element. The range of x differs depending on M. For example, x=0.1 to 2.0 when M is silicon (Si), x=0.1 to 1.5 when M is aluminum (A1), x=0.1 to 1.0 when M is magnesium (Mg), x=0.1 to 1.0 when M is calcium (Ca), x=0.1 to 0.5 when M is potassium (K), x=0.1 to 2.0 when M is tin (Sn), x=0.1 to 0.5 when M is sodium (Na), x=0.1 to 1.5 when M is boron (B), x=0.1 to 2.0 when M is titanium (Ti), x=0.1 to 1.0 when M is lead (Pb), x=0.1 to 2.0 when M is zirconium (Zr), and x=0.1 to 1.5 when M is yttrium (Y).

It is preferable to use silicone oxide (M=silicon), aluminum oxide (M=aluminum), or titanium oxide (M=titanium) due to excellent transparency and the like. It is more preferable to use silicon, oxide. It is preferable that x=1.0 to 2.0 when M is silicon, x=0.5 to 1.5 when M is aluminum, and x=1.3 to 2.0 when M is titanium.

Examples of the inorganic nitride include metal nitrides shown by MNy.
Note that M represents a metal element. The range of y differs depending on M. For example, y=0.1 to 1.3 when M is silicon (Si), y=0.1 to 1.1 when M is aluminum (Al), y=0.1 to 1.3 when M is titanium (Ti), and y=0.1 to 1.3 when M is tin (Sn).

It is preferable to use silicon nitride (M=silicon), aluminum nitride (M=aluminum), titanium nitride (M=titanium), or tin nitride (M=tin) due to excellent transparency and the like. It is more preferable to use silicon nitride (SiN). It is preferable that y=0.5 to 1.3 when M is silicon, y=0.3 to 1.0 when M is aluminum, y=0.5 to 1.3 when M is titanium, and y=0.5 to 1.3 when M is tin.

Examples of the inorganic oxynitride include metal oxynitrides shown by MOxNy.
Note that M represents a metal element. The ranges of x and y differ depending on M. For example, x=1.0 to 2.0 and y=0.1 to 1.3 when M is silicon (Si), x=0.5 to 1.0 and y=0.1 to 1.0 when M is aluminum (Al), x=0.1 to 1.0 and y=0.1 to 0.6 when M is magnesium (Mg), x=0.1 to 1.0 and y=0.1 to 0.5 when M is calcium (Ca), x=0.1 to 0.5 and y=0.1 to 0.2 when M is potassium (K), x=0.1 to 2.0 and y=0.1 to 1.3 when M is tin (Sn), x=0.1 to 0.5 and y=0.1 to 0.2 when M is sodium (Na), x=0.1 to 1.0 and y=0.1 to 0.5 when M is boron (B), x=0.1 to 2.0 and y=0.1 to 1.3 when M is titanium (Ti), x=0.1 to 1.0 and y=0.1 to 0.5 when M is lead (Pb), x=0.1 to 2.0 and y=0.1 to 1.0 when M is zirconium (Zr), and x=0.1 to 1.5 and y=0.1 to 1.0 when M is yttrium (Y).

It is preferable to use silicon oxynitride (M=silicon), aluminum oxynitride (M=aluminum), or titanium oxynitride (M=titanium) due to excellent transparency and the like. It is more preferable to use silicon oxynitride. It is preferable that x=1.0 to 2.0 and y=0.1 to 1.3 when M is silicon, x=0.5 to 1.0 and y=0.1 to 1.0 when M is aluminum, and x=1.0 to 2.0 and y=0.1 to 1.3 when M is titanium.
Note that the metal oxide, the metal nitride, and the metal oxynitride may include two or more types of metals.

The inorganic compound layer may be formed by an arbitrary method. For example, the inorganic compound layer may be formed by deposition, sputtering, ion plating, thermal CVD, plasma CVD, or the like. It is preferable to form the inorganic compound layer by sputtering since the inorganic compound layer can be easily formed.

When forming the inorganic compound layer by sputtering, a discharge gas (e.g., argon) is introduced into a vacuum chamber. A high-frequency voltage or a direct-current voltage is applied between an inorganic compound target and a substrate (e.g., plastic film) to generate plasma. The plasma collides with the target, so that the target material is splashed on the substrate, and adheres to the substrate to obtain a thin film. Examples of the target include the above metal oxides, metal nitrides, metal oxynitrides, and metals contained therein.

Examples spluttering include diode sputtering; triode sputtering that further utilizes a hot cathode that discharges thermoelectrons; magnetron sputtering that stabilizes plasma and increases the deposition rate by applying a magnetic field to the surface of the target using a magnetic field generating means; ion-beam sputtering that applies high-energy ion beams to the target; facing target sputtering that applies a magnetic field perpendicularly to the surface of two targets disposed in parallel; ECR sputtering that utilizes electron cyclotron resonance (ECR); coaxial sputtering that coaxially disposes the target and the substrate in a cylindrical shape; reactive sputtering that supplies a reactive gas to the vicinity of the substrate, and controls the composition; and the like.
Among these, it is preferable to use magnetron sputtering since a laminate that exhibits an excellent gas barrier capability can be easily obtained.

The inorganic compound layer may be formed by a dynamic ion mixing method. The dynamic ion mixing method forms a compound film of a film-forming material and ion species by forming a film while implanting ions. When using the dynamic ion mixing method, the composition and the crystals of the film can be easily controlled by changing the film-forming conditions and the ion implantation conditions. A film that has only a small number of pinholes and exhibits excellent mechanical properties can be formed by optimizing the conditions. Moreover, some of the atoms of the film-forming material that have reached the surface of the substrate material receive energy due to collision with the ions implanted into the film in the initial stage of the film-forming process, and are knocked-on in the substrate material. A mixing layer of the atoms of the substrate material and the atoms of the film-forming material is thus formed at the interface between the substrate material and the film. The mixing layer has a structure in which the atoms of the film-forming material that have entered the substrate material are like a wedge inserted into the substrate material, and function as an anchor that secures the deposited film on the substrate material. Therefore, the deposited film strongly adheres to the substrate material. Specifically, the inorganic compound layer formed by the dynamic ion mixing method strongly adheres to the polysilazane layer. Since the number of pinholes formed in the inorganic compound layer is small, an excellent gas barrier capability can be obtained, and cracks rarely occur when bending the inorganic compound layer, so that the gas barrier capability can be maintained for a long time.

When using the dynamic ion mixing method, it is preferable to form the inorganic compound layer by sputtering. In this case, the inorganic compound layer is formed as described below, for example.

Specifically, a substrate provided with a polysilazane layer and a target are disposed in a vacuum chamber. After reducing the pressure inside the vacuum chamber, a plasma-generating gas is introduced into the chamber. The plasma-generating gas includes a sputtering gas (rare gas), and optionally includes gas (reactive gas) other than the rare gas that undergoes ionization, and generates plasma when high-frequency electric power is applied to the substrate.

High-frequency electric power is then applied to the substrate while applying a high negative pulsed DC voltage. The plasma-generating gas generates plasma around the substrate due to the high-frequency electric power applied to the substrate, and the ions of the sputtering gas present in the plasma collide with the target, so that the sputtering particles fly out from the target. The sputtering particles adhere to (are deposited on) the surface of the polysilazane layer to form a deposited film (i.e., a film formed of the target material). The ions present in the plasma are attracted to the substrate due to the high negative pulsed DC voltage, and implanted into the deposited film (inorganic compound layer). Energy is thus applied to the atoms of the film, so that the atoms are knocked-on in the polysilazane layer. When using a reactive gas, the atoms of the film react with the ions of the reactive gas while the atoms are knocked-on in the polysilazane layer. As a result, a compound film (inorganic compound layer) of the target material and the reactive gas is formed to strongly adhere to the polysilazane layer.

When using the dynamic ion mixing method, an electrical charge of the substrate due to ion implantation can be removed by applying high-frequency electric power to the substrate.

The target and the plasma-generating gas are appropriately selected depending on the composition of the desired inorganic compound layer in the dynamic ion mixing method.

Specific examples of the target include the metal that forms the desired inorganic compound layer, silicon, graphite, metal-containing compounds (e.g., oxide, nitride, and oxynitride), and the like.

Examples of the sputtering gas include helium, argon, neon, krypton, xenon, and the like. These sputtering gases may be used either alone or in combination. Examples of the reactive gas include hydrogen, oxygen, nitrogen, fluorocarbon, and the like. These reactive gases may be used either alone or in combination.

When using reactive sputtering, it is preferable that the plasma-generating gas include a sputtering gas as the main component. The content of the sputtering gas in the plasma-generating gas is appropriately adjusted depending the compositional ratio of the target material and the desired film quality, but is preferably 50 to 100%, more preferably 55 to 98%, and particularly preferably 60 to 96%. This makes it possible to increase the deposition rate, so that the inorganic compound layer can be efficiently formed.

The pressure of the plasma-generating gas (the total pressure when using a mixed gas) is preferably 1.0×10¹ to 1.0×10⁻³ Pa, more preferably 1.0×10⁰ to 1.0×10⁻³ Pa, and particularly preferable 1.0×10 to 1.0×10⁻² Pa.

The high negative pulsed voltage applied to the substrate is preferably -100 kV to -100 V, and more preferably -50 kV to -1 kV.

The concentration of ions implanted into the film is normally 1×10¹⁵ ions/cm² or more, preferably 1×10¹⁶ ions/cm² or more, and more preferably 1 ×10¹⁶ to 1×10¹⁸ ions/cm².

The thickness of the inorganic compound layer is not particularly limited, but is preferably 10 to 1000 nm, more preferably 20 to 500 nm, and particularly preferably 50 to 200 nm, from the viewpoint of obtaining a gas barrier capability.

### Impact-absorbing layer

The formed article may include the impact-absorbing layer in order to prevent a situation in which the inorganic compound layer breaks due to impact. A material for forming the impact-absorbing layer is not particularly limited. Examples of the material for forming the impact-absorbing layer include acrylic resins, urethane resins, silicone resins, olefin resins, rubber materials, and the like. Among these, acrylic resins, silicone resins, and rubber materials are preferable.

Examples of the acrylic resins include acrylic resins that include at least one polymer selected from a (meth)acrylate homopolymer, a copolymer that includes two or more (meth)acrylate units, and a copolymer of a (meth)acrylate and another functional monomer, as the main component. Note that the term "(meth)acrylic acid" refers to acrylic acid or methacrylic acid (hereinafter the same).

It is preferable to use a (meth)acrylate in which the ester moiety has 1 to 20 carbon atoms, and more preferably a (meth)acrylate in which the ester moiety has 4 to 10 carbon atoms, since the storage modulus of the impact-absorbing layer can be easily adjusted within a given range. Examples of the (meth)acrylate include butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, (meth)acrylate, and the like.

Examples of the functional monomer include hydroxyl group-containing monomers such as hydroxyethyl (meth)acrylate, amide group-containing monomers such as (meth)acrylamide, carboxylic acid group-containing monomers such as (meth)acrylic acid, and the like.

The (meth)acrylate (co)polymer may be produced by solution polymerization, emulsion polymerization, suspension polymerization, or the like. Note that the term "(co)polymer" refers to a homopolymer or a copolymer (hereinafter the same).

The (meth)acrylate (co)polymer may be mixed with a crosslinking agent, and at least partially crosslinked.
Examples of the crosslinking agent include isocyanate crosslinking agents such as tolylene diisocyanate, hexamethylene diisocyanate, and adducts thereof; epoxy crosslinking agents such as ethylene glycol glycidyl ether; aziridine crosslinking agents such as hexa[1-(2-methyl)-aziridinyl]triphosphatriazine; chelate crosslinking agents such as aluminum chelates; and the like.

The crosslinking agent is used in an amount of 0.01 to 10 parts by mass, and preferably 0.05 to 5 parts by mass, based on 100 parts by mass (solid content) of the (meth)acrylate (co)polymer. These crosslinking agents may be used either alone or in combination.

Examples of the silicone resins include silicone resins that include a dimethylsiloxane as the main component. Examples of the rubber materials include rubber materials that include isoprene rubber, styrene-butadiene rubber, polyisobutylene rubber, styrene-butadiene-styrene rubber, or the like as the main component.

The impact-absorbing layer may include additives such as an antioxidant, a tackifier, a plasticizer, a UV absorber, a coloring agent, and an antistatic agent.

A product commercially available as a pressure-sensitive adhesive, a coating material, a sealing material, or the like may also be used as the material for forming the impact-absorbing layer. It is preferable to use a pressure-sensitive adhesive (e.g., acrylic pressure-sensitive adhesive, silicone pressure-sensitive adhesive, or rubber pressure-sensitive adhesive).

The impact-absorbing layer may be formed by an arbitrary method. For example, the impact-absorbing layer may be formed by applying a solution that includes the material (e.g., pressure-sensitive adhesive) for forming the impact-absorbing layer and an optional additional component (e.g., solvent) to a layer on which the impact-absorbing layer is to be formed, drying the resulting film, and optionally heating the dried film in the same manner as in the case of forming the polysilazane compound-containing layer.
Alternatively, the impact-absorbing layer may be deposited on a release base, and transferred to a layer on which the impact-absorbing layer is to be formed.
The thickness of the impact-absorbing layer is normally 1 to 100 µm, and preferably 5 to 50 µm.

### Conductor layer

Examples of a material for forming the conductor layer include metals, alloys, metal oxides, electrically conductive compounds, mixtures thereof, and the like. Specific examples of the material for forming the conductor layer include conductive metal oxides such as tin oxide, antimony-doped tin oxide (ATO), fluorine-doped tin oxide (FTO), zinc oxide, indium oxide, indium tin oxide (ITO), and indium, zinc oxide (IZO); metals such as gold, silver, chromium, and nickel; a mixture of a metal and a conductive metal oxide; inorganic conductive substances such as copper iodide and copper sulfide; organic conductive materials such as polyaniline, polythiophene, and polypyrrole; and the like. The conductor layer may be a laminate that includes a plurality of layers formed of these materials.
It is preferable to use a conductive metal oxide (particularly preferably ITO) as the material for forming the conductor layer from the viewpoint of transparency.

The conductor layer may be formed by deposition, sputtering, ion plating, thermal CVD, plasma CVD, or the like. It is preferable to form the conductor layer by sputtering since the conductor layer can be easily formed.

When forming the conductor layer by sputtering, a discharge gas (e.g., argon) is introduced into a vacuum chamber. A high-frequency voltage or a direct-currant voltage is applied between a target and a substrate to generate plasma, and plasma collides against the target so that the target material is splashed on the substrate, and adheres to the substrate to obtain a thin film. The target, is formed of the material for forming the conductor layer.

The thickness of the conductor layer may be appropriately selected defending on the application and the like. The thickness of the conductor layer is normally 10 nm to 50 µm, and preferably 20 nm to 20 µm.
The surface resistivity of the conductor layer is normally 1000 Ω/sq or less.

The conductor layer may optionally be patterned. The conductor layer may be patterned by chemical etching (e.g., photolithography), physical etching using a laser or the like, vacuum deposition using a mask, sputtering, a lift-off method, printing, or the like.

### Primer layer

The primer layer improves the interlayer adhesion between the base layer and the ion-implanted layer. A gas barrier film that exhibits excellent interlayer adhesion and surface flatness (smoothness) can be obtained by providing the primer layer.

An arbitrary known material may be used to form the primer layer. Examples of the material that may be used to form the primer layer includes silicon-containing compounds; a photopolymerizable composition that includes a photopolymerizable compound formed of a photopolymerizable monomer and/or a photopolymerizable prepolymer, and an initiator that generates radicals at least due to visible light; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like. These materials may be used either alone or in combination.

The primer layer may be formed by dissolving or dispersing the material for forming the primer layer in an appropriate solvent to prepare a primer layer-forming solution, applying the primer layer-forming solution to one side or each side of the base layer, drying the resulting film, and optionally heating the dried film.

The primer layer-forming solution may be applied to the base layer by a wet coating method. Examples of the wet coating method include dipping, roll coating, gravure coating, knife coating, air knife coating, roll knife coating, die coating, screen printing, spray coating, a gravure offset method, and the like.

The film formed using the primer layer-forming solution may be dried by hot-blast drying, heat roll drying, infrared irradiation, or the like. The thickness of the primer layer is formally 10 to 1000 nm.

Ions may be implanted into the primer layer in the same manner as in the case of forming the ion-implanted layer (described later), A gas barrier film that exhibits a more excellent gas barrier capability can be obtained by implanting ions into the primer layer.

The formed article according to one embodiment of the invention exhibits an excellent gas barrier capability, excellent transparency, and excellent antistatic performance. When the formed article is in the shape of a film or sheet (hereinafter referred to as "film-like shape"), the formed article exhibits excellent bending resistance, and maintains its gas barrier capability even when the formed article is bent.

The formed article according to one embodiment of the invention exhibits an excellent gas barrier capability since the formed article has a low gas (e.g., water vapor) transmission rate. For examples, the water vapor transmission rate of the formed article at a temperature of 40°C and a relative humidity of 90% is normally 1 g/m²/day or less, preferably 0.4 g/m²/day or less, and more preferably 0.1 g/m²/day or less. The gas (e.g., water vapor) transmission rate of the formed article may be measured using a known gas transmission rate measurement apparatus.

Whether or not the formed article according to one embodiment of the invention exhibits transparency may be confirmed by measuring the visible light transmittance of the formed article. The visible light transmittance (wavelength: 550 nm) of the formed article is preferably 55% or more. The visible light transmittance of the formed article may be measured using a known visible light transmittance measurement apparatus.

Whether or not the formed article exhibits excellent bending resistance, and maintains its gas barrier capability even when the formed article is bent may be confirmed by bonding the film-like formed article, applying a pressure to the formed article, and determining whether or not the bent area has deteriorated after unbending the formed article, and determining whether or not the water vapor transmission rate has decreased to a large extent. The film-like formed article according to one embodiment of the invention advantageously maintains its gas barrier capability as compared with an inorganic film having an identical thickness even when the formed article is bent.

Whether or not the formed article according to one embodiment of the invention exhibits antistatic performance may be confirmed by measuring the initial dielectric strength and the time required for the initial dielectric strength to attenuate by 50% (i.e., half-life) using a charge decay measurement apparatus, and measuring the surface resistivity of the formed article. The surface resistivity of the formed article is preferably 1×10¹⁴ Ω/sq or less, and more preferably 1×10¹² Q/sq or less. When the surface resistivity of the formed article is 1×10¹⁴ Ω/sq or less, the formed article exhibits excellent antistatic performance.

### 2) Method for producing formed article

A method for producing a formed article according to one embodiment of the invention includes implanting ions of a hydrocarbon compound into a polysilazane compound-containing layer of a formed body that includes the polysilazane compound-containing layer in a surface area.

It is preferable to implant ions of the hydrocarbon compound into the polysilazane compound-containing layer of a long formed body that includes the polysilazane compound-containing layer in a surface area while feeding a long formed body in a given direction.
According to this method, ions of the hydrocarbon compound can be implanted into the long formed body wound around a feed-out roll while feeding the formed body in a given direction, which can then be wound around a wind-up roll, for example. Therefore, a formed article into which ions of the hydrocarbon compound are implanted can be continuously produced.

The long formed body has a film-like shape. The long formed body may include only the polysilazane compound-containing layer, or may be a laminate that includes the polysilazane compound-containing layer in the surface area, and further includes an additional layer.

The thickness of the formed body is preferably 1 to 500 and more preferably 5 to 300 µm, from the viewpoint of winding/unwinding operability and feeding operability.

Ions of the hydrocarbon compound may be implanted into the polysilazane compound-containing layer by an arbitrary method. It is specifically preferable to form an ion-implanted layer in the surface area or the polysilazane compound-containing layer using the plasma ion implantation method.

The plasma ion implantation, method includes implanting ions present in plasma into the surface area of the polysilazane compound-containing layer by applying a negative high voltage pulse to the formed body that includes the polysilazane compound-containing layer in the surface area and is exposed to plasma.

It is preferable to use (A) a plasma ion implantation method that implants ions present in plasma generated by utilizing an external electric field into the surface area of the polysilazane compound-containing layer, or (B) a plasma ion implantation method that implants ions present in plasma generated due to an electric field produced by applying a negative high voltage pulse to the polysilazane compound-containing layer into the surface area of the polysilazane compound-containing layer.

When using the method (A), it is preferable to set the ion implantation pressure (plasma ion implantation pressure) to 0.01 to 1 Pa. When the ion implantation, pressure is within the above range, a uniform ion-implanted layer that exhibits an excellent gas barrier capability and the like can be conveniently and efficiently formed.

The method (B) does not require increasing the degree of decompression, allows a simple operation, and significantly reduces the processing time. Moreover, the entire polysilazane compound-containing layer can be uniformly processed, and ions present in plasma can be continuously implanted into the surface area of the polysilazane compound-containing layer with high energy when applying a negative high voltage pulse. The method (B) also has an advantage in that an excellent ion-implanted layer can be uniformly formed in the surface area of the polysilazane compound-containing layer by merely applying a negative high voltage pulse to the polysilazane compound-containing layer without requiring a special means such as a high-frequency electric power supply (e.g., radio frequency (RF) power supply or microwave power supply).

When using the method (A) or (B), the pulse width when applying a negative high voltage pulse (i.e., during ion implantation) is preferably 1 to 15 µs. When the pulse width is within the above range, a transparent and uniform ion-implanted layer can be formed more conveniently and efficiently.

The voltage applied when generating plasma is preferably -1 to -50 kV, more preferably -1 to -30 kV, and particularly preferably -5 to -20 kV. If the applied voltage is higher than -1 kV, the dose may be insufficient, so that the desired performance may not be obtained. If the applied voltage is lower than -50 key the formed article may be charged during ion implantation, or the formed article may be colored, for example.

Examples of a raw material gas that produces plasma ions of the hydrocarbon compound include those mentioned above in connection with the formed article.

A plasma ion implantation apparatus is used when implanting ions present in plasma into the surface area of the polysilazane compound-containing layer.
Specific examples of the plasma ion implantation apparatus includes (a) an apparatus that causes the polysilazane compound-containing layer (hereinafter may be referred to as "ion implantation target layer") to be evenly enclosed by plasma by superimposing high-frequency electric power on a feed-through that applies a negative high voltage, pulse to the ion implantation target layer so that ions present in the plasma are attracted to and collide with the target, and thereby implanted and deposited therein (JP-A-2001-26887), (β) an apparatus that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and implanted into the target while heating the ion implantation target layer, causing electrons present in the plasma to be attracted to and collide with the target due to the positive pulse, and applying the negative pulse while controlling the temperature by controlling the pulse factor (JP-A-2001-156013), (γ) a plasma ion implantation apparatus that generates plasma using an external electric field utilizing a high-frequency electric power supply such as a microwave power supply, and causes ions present in the plasma to be attracted to and implanted into the target by applying a high voltage pulse, (δ) a plasma ion implantation apparatus that implants ions present in plasma generated due to an electric field produced by applying a high voltage pulse without using an external electric field, and the like.

It is preferable to use the plasma ion implantation apparatus (γ) or (δ) since the plasma ion implantation apparatus (γ) or (δ) allows a simple operation, significantly reduces the processing time, and can be continuously used.
A method that utilizes the plasma ion implantation apparatus (γ) or (δ) is described in detail below with reference to the drawings.

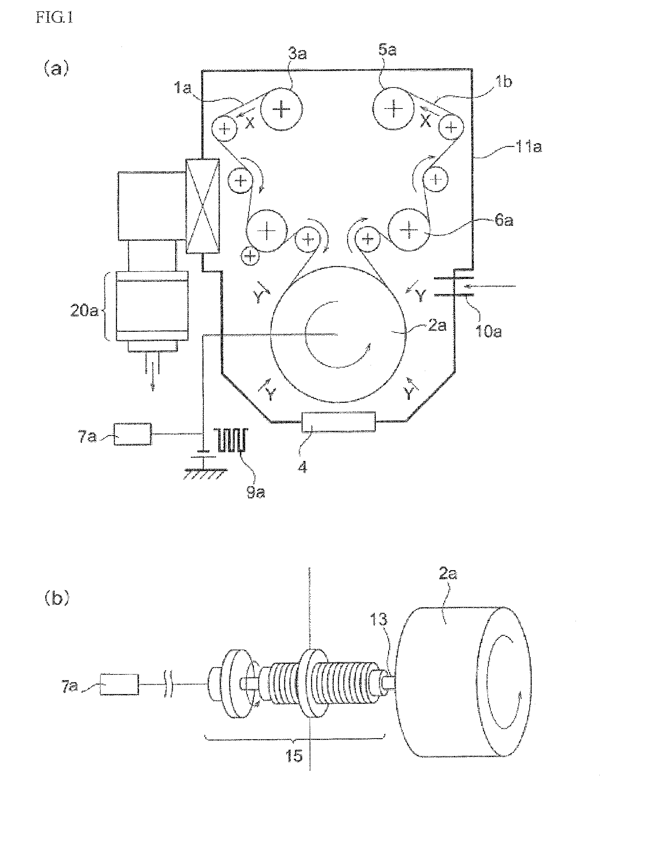

FIG. 1(a) is a view schematically illustrating a continuous plasma ion implantation apparatus that includes the plasma ion implantation apparatus (γ).
In FIG. 1 (a), reference sign 1a indicates a long film-like formed body (hereinafter referred to as "film") that includes a polysilazane compound-containing layer in the surface area, reference sign 11a indicates a chamber, reference sign 20a indicates a turbo-molecular pump, reference sign 3a indicates a feed-out roll around which the film 1a is wound before ion implantation, reference sign 5a indicates a wind-up roll around which an ion-implanted film (formed article) 1a is wound, reference sign 2a indicates a high-voltage applying rotary can, reference sign 6a indicates a driving roll, reference sign 10a indicates a gas inlet, reference sign 7a indicates a high voltage pulsed power supply, and reference sign 4 indicates a plasma discharge electrode (external electric field). FIG. 1(b) is a perspective view illustrating the high-voltage applying rotary can 2a, wherein reference sign 15 indicates a high-voltage application terminal (feed-through).

The long film 1a that includes the polysilazane compound-containing layer in the surface area is a film in which a polysilazane compound-containing layer is formed on a base layer.

In the continuous plasma ion implantation apparatus illustrated in FIG. 1(a), tic film 1a is fed from the feed-out roll 3a in the direction of an arrow X inside the chamber 11a, passes through the high-voltage applying rotary can 2a, and is wound around the wind-up roll 5a. The film 1a may be wound and fed (carried) by an arbitrary method. In one embodiment, the film 1a is fed (carried) by rotating the high-voltage applying rotary can 2a at a constant speed. The high-voltage applying rotary can 2a is rotated by rotating a center shaft 13 of the high-voltage application terminal 15 using a motor.

The high-voltage application terminal 15, the driving rolls 6a that come in contact with the film 1a, and the like are formed of an insulator. For example, the high-voltage application terminal 15, the driving rolls 6a, and the like are formed by coating the surface of alumina with a resin (e.g., polytetrafluoroethylene). The high-voltage applying rotary can 2a is formed of a conductor (e.g., stainless steel).

The feeding speed of the film 1a may be appropriately set. The feeding speed of the film 1a is not particularly limited as long as ions are implanted into the surface (polysilazane compound-containing layer) of the film 1a so that the desired ion-implanted layer is formed when the film 1a is fed from the feed-out roll 3 a and wound around the wind-up roll 5a. The film winding speed (feeding speed) is determined depending on the applied voltage, the size of the apparatus, and the like, but is normally 0.1 to 3 m/min, and preferably 0.2 to 2.5 m/min.

The pressure inside the chamber 11a is reduced by discharging air from the chamber 11a using the turbo-molecular pump 20a connected to a rotary pump. The degree of decompression is normally 1×10⁻⁴ to 1 Pa, and preferably 1×10⁻³ to 1×10⁻² Pa.

The ion implantation gas of the hydrocarbon compound (hereinafter may be referred to as "ion implantation gas") is introduced into the chamber 11a through the gas inlet 10a so that the chamber 11a is filled with the ion implantation gas under reduced pressure. Note that the ion implantation gas also serves as a plasma-generating gas.

Plasma is then generated using the plasma discharge electrode 4 (external electric field). The plasma may be generated by a known method using a high-frequency electric power supply (e.g., RF power supply or microwave power supply).

A negative high voltage pulse 9a is applied from the high voltage pulsed power supply 7a connected to the high-voltage applying rotary can 2a through the high-voltage application terminal 15. When a negative high voltage pulse is applied to the high-voltage applying rotary can 2a, ions present in the plasma are attracted to and implanted into the surface of the film around the high-voltage applying rotary can 2a (arrow Y in FIG. 1(a)), so that a film-like formed article 1b is obtained.

The pressure during ion implantation (i.e., the pressure of plasma, gas inside the chamber 11a) is preferably 0.01 to 1 Pa. The pulse width during ion implantation is preferably 1 to 15 5 µs. The negative high voltage applied to the high-voltage applying rotary can 2a is preferably -1 to -50 kV.

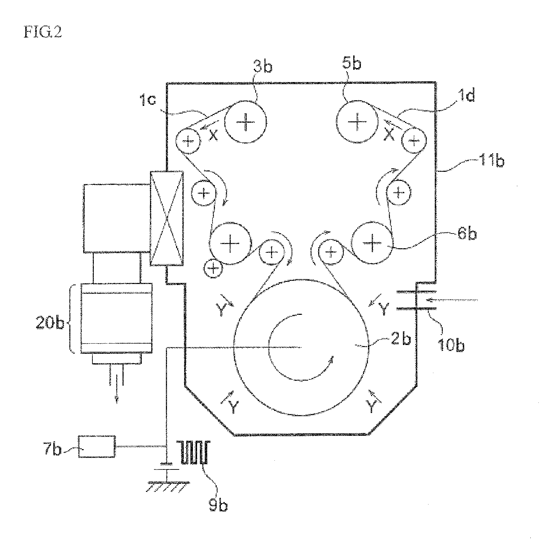

When using a continuous plasma ion implantation apparatus illustrated in FIG. 2, ions are implanted into a polysilazane compound-containing layer of a film that includes the polysilazane compound-containing layer in the surface area as described below.

The apparatus illustrated in FIG. 2 includes the plasma ion implantation apparatus (δ). The plasma ion implantation, apparatus (δ) generates plasma by applying only an electric field due to a high voltage pulse without using an external electric field (i.e., the plasma discharge electrode 4 illustrated in FIG. 1).

In the continuous plasma ion implantation, apparatus illustrated in FIG. 2, a film 1c (film-like formed body) is fed from a feed-out roll 3b in the direction of an narrow X (see FIG. 2) by rotating a high-voltage applying rotary can 2b, and wound around a wind-up roll 5b.

The continuous plasma ion implantation apparatus illustrated in FIG. 2 implants ions into the surface of the polysilazane compound-containing layer of the film as described below.

The film 1c is placed in a chamber 11b in the same manner as the plasma ion implantation apparatus illustrated in FIG. 1. The pressure inside the chamber 11b is reduced by discharging air from the chamber 11b using a turbo-molecular pump 20b connected to a rotary pump. An ion implantation gas is introduced into the chamber 11b through a gas inlet 10b so that the chamber 11b is filled with the ion implantation gas under reduced pressure.

The pressure during ion implantation (i.e., the pressure of plasma gas inside the chamber 11b) is 10 Pa or less, preferably 0.01 to 5 Pa, and more preferably 0.01 to 1 Pa.

A high voltage pulse 9b is applied from a high voltage pulsed power supply 7b connected to the high-voltage applying rotary can 2b through a high-voltage application terminal (not shown) while feeding the film 1c in the direction X illustrated in FIG. 2.

When a negative high voltage pulse is applied to the high-voltage applying rotary can 2b, plasma is generated along the film 1c positioned around the high-voltage applying rotary can 2b, and ions present in plasma are attracted to and implanted into the surface of the film 1c around the high-voltage applying rotary can 2b (arrow Y in FIG. 2). When ions have been implanted into the surface of the polysilazane compound-containing layer of the film 1c, an ion-implanted layer is formed in the surface of the film. A film-like formed article 1d is thus obtained.

The applied voltage and the pulse with employed when applying a negative high voltage pulse to the high-voltage applying rotary can 2b, and the pressure employed during ion implantation are the same as those employed when using the continuous plasma ion implantation, apparatus illustrated in FIG. 1.

Since the plasma ion implantation apparatus illustrated in FIG. 2 is configured so that the high voltage pulsed power supply also serves as a plasma generation means, a special means such as a high-frequency electric power supply (e.g., RF power supply or microwave power supply) is unnecessary. An ion-implanted layer can be continuously formed by implanting ions present in the plasma into the surface area of the polysilazane compound-containing layer by merely applying a negative high voltage pulse. Therefore, a formed article in which an ion-implanted layer is formed in the surface area of a film can be mass-produced.

### 3) Electronic device member and electronic device

An electronic device member according to one embodiment of the invention includes the formed article according to one embodiment of the invention. Therefore, since the electronic device member according to one embodiment of the invention exhibits an excellent gas barrier capability, a deterioration in an element (member) due to gas (e.g., water vapor) can be prevented. Since the electronic device member exhibits high light transmittance, the electronic device member may suitably be used as a display member for liquid crystal displays and EL displays; a solar cell backsheet; and the like.

An electronic device according to one embodiment of the invention includes the electronic device member according to one embodiment of the invention. Specific examples of the electronic device include a liquid crystal display, an organic EL display, an inorganic EL display, electronic paper, a solar cell, and the like.
Since the electronic device according to one embodiment of the invention includes the electronic device member that includes the formed article according to one embodiment of the invention, the electronic device exhibits an excellent gas barrier capability and excellent transparency.

### EXAMPLES

The invention is further described below by way of examples. Note that the invention is not limited to the following examples.

A plasma ion implantation apparatus, a water vapor transmission rate measurement apparatus, water vapor transmission rate measurement conditions, a visible light transmittance measurement apparatus, a charged-voltage and half-life of charge decay measurement apparatus, dielectric strength/half-life measurement conditions, a surface resistivity measurement apparatus, and a bending test method used in the examples are as follows. Note that an apparatus that implants ions using an external electric field was used as the plasma ion implantation apparatus.

### Plasma ion implantation apparatus

RF power supply: "RF56000" manufactured by JEOL Ltd.
High voltage pulsed power supply: "PV-3-HSHV-0835" manufactured by Kurita Seisakusho Co., Ltd.

### Measurement of water vapor transmission rate

The water vapor transmission rate was measured using a transmission rate tester "L89-500" (manufactured by LYSSY) (when the water vapor transmission rate was 0.01 g/m²/day or more) or "DELTAPERM" (manufactured by Technolox Ltd.) (when the water vapor transmission rate was less than 0.01 g/m²/day).
Measurement conditions: relative humidity: 90%, temperature: 40°C

### Measurement of visible light transmittance

Measurement apparatus: UV-3101PC (manufactured by Shimadzu Corporation)
Measurement conditions: wavelength: 550 nm

### Measurement of charged-voltage and half-life

The formed article was placed on a turntable of a charge decay measurement apparatus ("STATIC HONESTMETER Type S-5109" manufactured by Shishido Electrostatic, Ltd.) so that the ion-implanted layer (side) (the perhydropolysilazane-containing layer in Comparative Example 1, and the silicon nitride film in Comparative Example 4) faced upward, and the charged-voltage and the time required for the initial charged-voltage to attenuate by 50% (i.e., half-life) were measured at an output voltage of 10 kV and a rotational speed of 1300 rpm. When the half-life was 60 seconds or more, the charged-voltage when 60 seconds had elapsed was measured.

### Measurement of surface resistivity

The surface resistivity of the ion-implanted layer (side) (the perhydropolysilazane-containing layer in Comparative Example 1, and the silicon nitride film in Comparative Example 4) of the formed article was measured using a high resistivity meter "Hiresta UP MCP-HT450" (manufactured by Mitsubishi Chemical Corporation).

### Bending test

The formed article was bent at the center so that the side of ion-implanted layer (the surface of the perhydropolysilazane-containing layer in Comparative Example 1, and the surface of the silicone nitride film in Comparative Example 4) was positioned on the outer side. The formed article was passed between two rolls of a laminator ("LAMIPACKER LPC1502" manufactured by Fujipla, Inc.) at a laminating speed of 5 m/min and a temperature of 23°C. The bent area was observed using a microscope (magnification: 100) to determine the presence or absence of cracks. A case where cracks were not observed is indicated by "No", and a case where cracks were observed is indicated by "Yes".

### Example 1

A coating material containing perhydropolysilazane (polysilazane compound) as the main component ("Aquamika NL110-20" manufactured by Clariant Japan K.K.) was applied to a polyethylene terephthalate film ("PET38 T-100" manufactured by Mitsubishi Plastics Inc., thickness: 38 µm (hereinafter referred to as "PET film")) (base layer), and heated at 120°C for 1 minute to form a perhydropolysilazane-containing layer (thickness: 100 nm) on the PET film. A formed body was thus obtained.
Acetylene was plasma-ion-implanted into the surface of the perhydropolysilazane-containing layer of the formed body under the following conditions using the plasma ion implantation apparatus illustrated in FIG. 1 to obtain a formed article 1.

Plasma ion implantation conditions
Plasma-generating gas: acetylene
Gas flow rate: 100 seem
Duty ratio: 0.5%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 µs
Processing time (ion implantation time): 5 minutes
Feeding speed: 0.2 m/min

### Example 2

A formed article 2 was obtained in the same manner as in Example 1, except for using toluene (gas flow rate: 30 sccm) as the plasma-generating gas instead of acetylene.

### Example 3

A formed article 3 was obtained in the same manner as in Example 1, except for using methane as the plasma-generating gas instead of acetylene.

### Comparative Example 1

A formed article was obtained in the same manner as in Example 1, except that ion implantation was not performed. Specifically, a formed article 4 was obtained by forming a perhydropolysilazane-containing layer on the PET film.

### Comparative Example 2

A formed article was obtained in the same manner as in Example 1, except that the perhydropolysilazane-containing layer was not formed on the PET film. Specifically, a formed article 5 was obtained by plasma ion implantation of acetylene into the surface of the PET film under the same conditions as those employed in Example 1.

### Comparative Example 3

A formed article was obtained in the same manner as in Example 2, except that the perhydropolysilazane-containing layer was not formed on the PET film. Specifically, a formed article 6 was obtained by plasma ion implantation of toluene into the surface of the PET film under the same conditions as those employed in Example 1 (except that the gas flow rate was 100 seem).

### Comparative Example 4

A silicon nitride (SiN) film (thickness: 60 nm) was formed on a PET film by sputtering to obtain a formed article 7.

### Reference Example 1

A formed article 8 was obtained in the same manner as in Example 1, except for using argon (Ar) (gas flow rate: 100 sccm) as the plasma-generating gas instead of acetylene.

The formed articles 1 to 3, 5, 6, and 8 obtained in Examples 1 to 3, Comparative Examples 2 and 3, and Reference Example 1) were subjected to elemental analysis in the surface area up to a depth of about 10 nm using an XPS apparatus (manufactured by ULVAC-PHI, Incorporated). It was confirmed that ions had been implanted into the formed articles 1 to 3, 5, 6, and 8.

The water vapor transmission rate, the visible light transmittance, the dielectric strength, the half-life, and the surface resistivity of the formed articles 1 to 6 obtained in Examples 1 to 3, Comparative Examples 2 and 3, and Reference Example 1 were measured. The measurement results are shown in Table 1.

The formed articles 1 to 6 were also subjected to the bending test to determine the presence or absence of cracks. The results are shown in Table 1.
The water vapor transmission rate of the formed articles 1 to 6 was measured after the bending test. The results are shown in Table 1.

**TABLE 1**

| | Formed article | Water vapor transmission rate (g/m²/day) | Visible light transmittance (%) | Charged-voltage (mV) | | | Surface resistivity (Ω/sq) | Cracks | Water vapor transmission rate after bending test (g/m²/day) |
|---|---|---|---|---|---|---|---|---|---|
| | | | | Initial charged-voltage (mV) | Half-life (s) | Charged-voltage after 60 seconds (mV) | | | |
| Example 1 | 1 | 0.03 | 78.7 | 0.6 | 3 | 0 | 5.16×10¹⁰ | No | 0.13 |
| Example 2 | 2 | 0.02 | 58.3 | 1.8 | 36 | 0 | 1.00×10¹² | No | 0.18 |
| Example 3 | 3 | 0.06 | 88.8 | 1.9 | - | 1.9 | 6.34×10¹³ | No | 0.15 |
| Comparative Example 1 | 4 | 12.2 | 92.0 | 2.0 | - | 2.0 | 1.0×10¹⁵ or more | No | 12.6 |
| Comparative Example 2 | 5 | 11.8 | 74.2 | 0.7 | 3 | 0 | 5.76×10¹⁰ | No | 12.0 |
| Comparative Example 3 | 6 | 12.0 | 56.3 | 1.8 | 40 | 0 | 9.23×10¹¹ | No | 12.2 |
| Comparative Example 4 | 7 | 0.43 | 82.3 | 2.0 | - | 2.0 | 7.55×10¹⁴ | Yes | 1.6 |
| Reference Example 1 | 8 | 0.03 | 87.7 | 2.0 | - | 2.0 | 2.38×10¹³ | No | 0.12 |

As shown in Table 1, the formed articles 1 to 3 obtained in Examples 1 to 3 had a low water vapor transmission rate (i.e., exhibited an excellent gas barrier capability) as compared with the formed articles 4 and 7 obtained in Comparative Examples 1 to 4.
The formed articles 1 and 2 obtained in Examples 1 and 2 had a short dielectric strength half-life and a low surface resistivity (i.e., exhibited excellent antistatic performance).
The formed articles 1 to 3 obtained in Examples 1 to 3 and the formed article 8 obtained in Reference Example 1 showed no cracks, and maintained a small water vapor transmission rate after the bending test (i.e., exhibited excellent bending resistance).

### REFERENCE SIGNS LIST

- 1a, 1c:: film-like formed body
- 1b, 1d:: film-like formed article
- 2a, 2b:: rotary can
- 3a, 3b:: feed-out roll
- 4:: plasma discharge electrode
- 5a, 5b:: wind-up roll
- 6a, 6b:: driving roll
- 7a, 7b:: pulsed power supply
- 9a, 9b:: high voltage pulse
- 10a,: 10b: gas inlet
- 11a, 11b:: chamber
- 13:: center shaft
- 15:: high-voltage application terminal
- 20a, 20b:: turbo-molecular pump

## Claims

1. A formed article comprising a layer obtained by implanting ions of a hydrocarbon compound into a polysilazane compound-containing layer.

2. The formed article according to claim 1, wherein the layer has been obtained by implanting ions of the hydrocarbon compound into the polysilazane compound-containing layer by a plasma ion implantation method.

3. The formed article according to claim 1 or 2, wherein the polysilazane compound is perhydropolysilazane.

4. The formed article according to claim 1 or 2, the formed article having a water vapor transmission rate at a temperature of 40°C and a relative humidify of 90% of 0.4 g/m²/day or less.

5. The formed article according to claim 1 or 2, the formed article having a surface resistivity of 1×10¹⁴ Ω/sq or less.

6. A method for producing the formed article according to claim 1 or 2, the method comprising implanting ions of a hydrocarbon compound into a surface area of a polysilazane compound-containing layer of a formed body that includes the polysilazane compound-containing layer in a surface area.

7. A method for producing the formed article according to claim 1 or 2, the method comprising implanting ions of a hydrocarbon compound into a polysilazane compound-containing layer of a long formed body that includes the polysilazane compound-containing layer in a surface area while feeding the formed body in a given direction.

8. An electronic device member comprising the formed article according to claim 1 or 2.

9. An electronic device comprising the electronic device member according to claim 8.
